# EUROPEAN PATENT APPLICATION

(11) **EP 0 543 542 A2**
(43) Date of publication of application: **26.05.1993**
(21) Application number: 92310193.5
(22) Date of filing: 06.11.1992
(51) Int. Cl.: G06F 1/06, G06F 1/10, H03K 5/15

(54) **High speed clock circuit for multiple clock receivers with minimum skew**

(30) Priority: 21.11.1991 US 795538
(71) Applicant: SUN MICROSYSTEMS, INC., Mountain View, CA 94043 (US)
(72) Inventor: Testa, James, Mountain View, California 94043 (US)
(74) Representative: Wombwell, Francis

(57) **Abstract**

A high speed clock circuit is disclosed that solves clock skew problems in a data processing system by employing a separate driver for each clock output, by containing the clock circuit on an integrated circuit chip, by matching clock signal trace lengths internal to the clock chip, and by matching circuit board clock signal trace lengths. The clock circuit receives a source clock input signal and generates multiple clock outputs at one half the frequency of the source clock and multiple clock outputs at one fourth the frequency of the source clock. A clock distribution circuit receives a bus clock signal and uses double drivers to transmit the bus clock signal to a common point on the integrated circuit die. There is a separate output driver for each clock output. From the common point on the die, equal length traces are routed to each output driver. Each output driver provides the signal strength necessary to transmit a clock output signal off the chip through an output pin to final destination. Trace lengths from the output pins of the clock chip to the final destinations of the clock signals should be matched to reduce skew caused by variations in the length, and capacitance of circuit board traces.

## Description

### Background of the Invention

### 1. FIELD:

This invention relates to the field of data processing systems. More particularly, this invention relates to clock circuits used to synchronize various elements of a data processing system.

### 2. ART BACKGROUND:

A common requirement of a data processing system is that each of the various elements of the system act in harmony. Harmony, or synchronization, is usually accomplished by providing a common dock signal to each element of the system. However, when the clock signals are routed to the various components of the system, some clock signals arrive at their destination before others. This phenomenon is known as clock skew. Clock skew limits the speed of a data processing system because the amount of clock skew is directly subtracted from the cycle time of the common clock, yielding the usable portion of the cycle time for the system logic. Thus, the larger the clock skew, the smaller the usable portion of the cycle time

Clock skew can have a number of causes. It may be caused by variations in path lengths from the clock generator to the various components of the system. It may be caused by manufacturing variations and operating temperature variation among the drivers and receivers used to transmit the clock signals. Clock skew may also be caused by differences in the impedance and the capacitance of signal lines carrying the clock signals to their destination. Variation in signal line impedance and capacitance is an acute problem in systems that connect multiple clock signal lines to one clock driver.

In the past, a common solution to the clock skew problem was to employ a clock generating chip that has a single clock input with multiple clock outputs. However, this solution is viable only if a system needs just a few clock outputs because such clock generating chips typically provide a maximum of six clock outputs. Moreover, if more than one clock signal line is connected to a clock output, the impedance and capacitance variation among signal lines can cause severe clock skew due to reflections on the signal traces produced by impedance discontinuities. Thus, to reduce clock skew, each clock output should be used to drive only one point to point clock signal line. This results in clock skew composed of the speed of light delay and capacitor charging time.

However, the consequential small number of clock signals available from such clock chips gives rise to problems in data processing systems requiring a large number of clock outputs. For example, a data processing system needing clock signals for 18 separate components would require using three clock chips having six outputs each. In addition, one clock chip would be needed to drive the above three clock chips in order to generate 18 outputs. There are usually manufacturing variations and operating temperature variation between each of the clock chips. As a consequence, the clock outputs of a given clock chip will be skewed with respect to the clock outputs of another.

The problem of clock skew has become more significant because of the higher speeds that are sought by designers of data processing systems. The higher the speed at which a data processing system functions, the lower the margin for error in clock signals that can be tolerated. Clock skew effectively places a limit on the speed of a data processing system because clock skew limits the usable cycle time available to the system logic.

As will be described, the present invention provides a high speed clock circuit which reduces clock skew and overcomes the problems associated with prior art clock circuits.

### Summary of the Invention

A high speed clock circuit is disclosed that solves the problem of clock skew in a data processing system by embodying a three pronged approach to eliminate the causes of clock skew. First, the clock circuit employs a separate driver for each clock signal in order to eliminate skew caused by impedance and capacitance variation among multiple signal lines connected to one output driver. Second, the clock circuit is contained on an integrated circuit chip in order to eliminate skew caused by temperature and process technology differences among output drivers. Third, the internal signal traces on the clock chip of the present invention are matched to eliminate skew between the clock signals at the output pins of the clock chip.

The high speed clock circuit of the present invention receives a source clock input signal and generates multiple clock outputs at one half the frequency of the source clock and multiple clock outputs at one fourth the frequency of the source clock. The source clock signal is input to a divider circuit which divides it in frequency by 2 to generate a first bus clock. The first bus clock is input into another divider which divides it in frequency by 2 to produce a second bus clock. An exclusive-OR gate between the two dividers guarantees minimum skew between the divider outputs. The first bus clock is input to a first clock distribution circuit that produces multiple first bus clock outputs. The second bus clock is input to second clock distribution circuit that produces multiple second bus clock outputs. Each clock distribution circuit operates in a similar manner, the only difference being the number of clock outputs generated.

A clock distribution circuit receives one of the bus clocks and uses double drivers to transmit the bus clock to a common point on the integrated circuit die. There is a separate output driver for each clock output. From the common point on the die, equal length traces are routed to each output driver. Each output driver provides the signal strength necessary to transmit a clock output off the chip through an output pin to the final destination. Trace lengths from the output pins of the clock chip to the final destinations of the clock signals should be matched to reduce skew caused by variations in the length, capacitance and impedance of circuit board traces.

### Brief Description of the Drawings

**Figure 1** illustrates the circuit used to receive the source clock signal and generate one half and one quarter frequency clock signals.

**Figure 2** illustrates the operation of the clock distribution circuit used to generate multiple clock outputs from a single clock input.

**Figure 3** illustrates the timing of the source clock and the first bus clock and the second bus clock.

### Detailed Description of the Invention

A high speed clock circuit is disclosed for providing clock signals in data processing systems. In the following description for purposes of explanation, numerous details are set forth such as specific circuit components, circuit paths, etc., in order to provide a thorough understanding of the present invention. However, it will be apparent to one skilled in the art that these specific details are not required to practice the present invention. In other instances well known electrical structures and circuits are shown in order not to obscure the present invention unnecessarily.

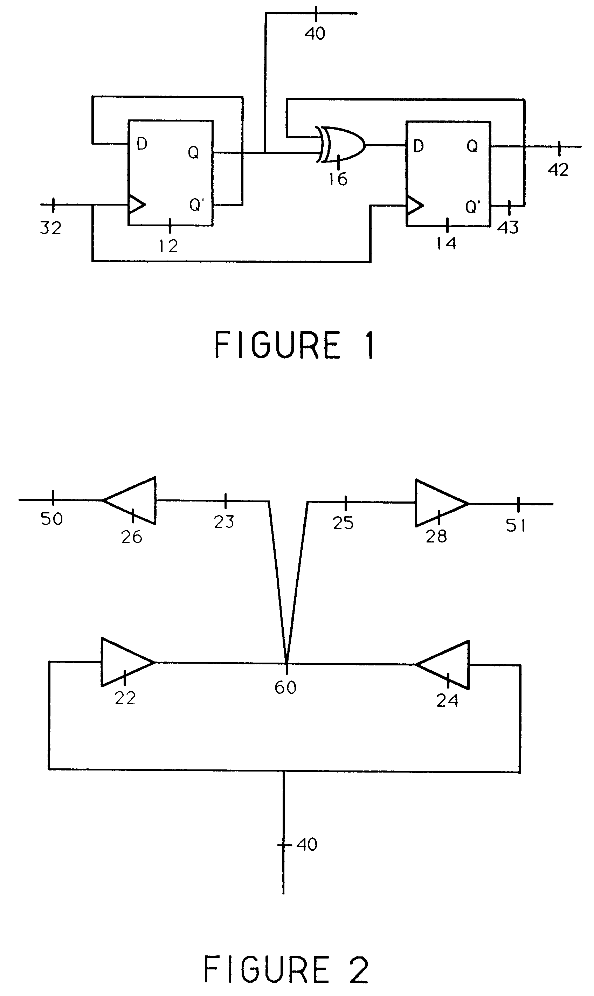

The high speed clock circuit of the present invention solves the problem of clock skew in a data processing system by directly eliminating three causes of clock skew. First of all, the clock circuit uses a separate driver for each clock output. Referring briefly to **Figure 2**, an example of the clock distribution circuit of the present invention is illustrated. A separate output driver, such as driver 26 or driver 28, is provided for each clock output of the circuit. This eliminates the need to connect multiple clock signal lines to one output driver. The result is an elimination of skew caused by variation in impedance and capacitance among signal lines that would otherwise be connected to the same output driver.

Secondly, the high speed clock circuit of the present invention is contained upon a single integrated circuit chip. This eliminates skew caused by temperature variation among output drivers because all of the output drivers will run at the same temperature. Containing the clock circuit on a single chip also eliminates clock skew resulting from process technology differences among output drivers, because all output drivers are fabricated on the same chip.

Thirdly, the length of signal line traces from the source dock drivers to each of the output drivers on the integrated circuit chip are matched. Referring again briefly to **Figure 2**, the clock distribution circuit is shown with separate signal traces 23 and 25 routed to output drivers 26 and 28. Signal traces 23 and 25 have the same length so that each clock signal arrives at an output driver at the same time. This eliminates clock skew internal to the clock circuit on the chip.

The high speed clock circuit of the present invention receives a source clock signal and generates multiple clock outputs at one half the frequency of the source clock and multiple clock outputs at one fourth the frequency of the source clock. However, it will be appreciated by one skilled in the art that the invention can be adapted to generate clock outputs at the frequency of the source clock or at frequencies at other fractions of the source clock.

**Figure 1** illustrates the circuit used to receive the source clock signal and to generate one half and one quarter frequency bus clock signals. Divider 12 receives the source clock signal over signal line 32 and produces the first bus clock at signal line 40. The frequency of the first bus clock is one half the frequency of the source clock. The first bus clock is input to the first clock distribution circuit. The first bus clock is also input to divider 14 through exclusive-OR gate 16. Output signal line 42 of divider 14 provides the second bus clock. The complimentary output signal line 43 of divider 14 is input to gate 16 in order to guarantee minimum skew between the first bus clock and the second bus clock. The second bus clock is input to the second clock distribution circuit. The frequency of the second bus clock is one fourth the frequency of the source clock.

Referring to **Figure 2**, an example of the clock distribution circuit that generates multiple first bus clock outputs is provided. The first bus clock is input to the clock distribution circuit over signal line 40. As shown in **Figure 2**, signal line 40 is connected to two drivers labeled 22 and 24. The outputs of drivers 22 and 24 are connected together at a common point on the integrated circuit die represented by node point 60. From the common point, signal lines 23 and 25 carry the clock signal to two separate output drivers labeled 26 and 28. Signal lines 23 and 25 are of equal length so that the clock signal will arrive at both drivers 26 and 28 at the same time. Output drivers 26 and 28 transmit the clock signals over signal lines 50 and 51 to output pins of the integrated circuit chip. The result is that signal lines 50 and 51 of **Figure 2** provide synchronized first bus clock outputs. Drivers 26 and 28 provide the signal strength necessary to drive the clock signals off the chip to their destination.

Additional first bus clock outputs can be produced with the addition of more output drivers, such as drivers 26 and 28, having outputs connected to output pins of the chip. The input of each additional driver must be connected to node point 60 by a signal trace having a length equal to the lengths of signal lines 23 and 25. In the current embodiment, 14 first bus clock outputs are provided by using 14 output drivers. A similar clock distribution circuit is used to distribute the second bus clock generated by the circuit of **Figure 1**. The current embodiment of the present invention generates 6 second bus clock outputs by using 6 output drivers.

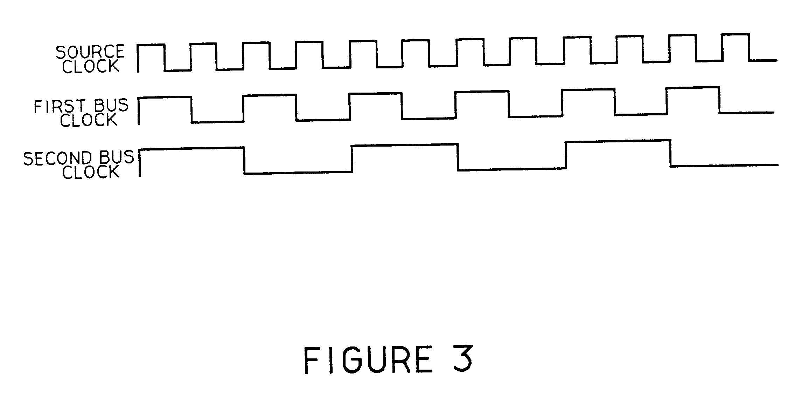

**Figure 3** illustrates the timing of the source clock and the first bus clock and the second bus clock. The first bus clock and the second bus clock are synchronized to the source clock. There is minimal skew between leading edges of each of the clocks. The first bus clock has one half the frequency of the source clock. The second bus clock has one fourth the frequency of the source clock.

In a typical data processing system, the clock chip is contained on a circuit board, while the various components to be synchronized are disposed on the same circuit board or on other circuit boards of the system. Variations in the length, capacitance and impedance of circuit board traces used to route the clock signals to various components of the system can give rise to skew between the clock signals when measured at the point of reception. To minimize such skew, trace lengths from the output pins of the clock chip to the final destinations of the clock signals should be matched. This will compensate for all clock skew caused by signal routing, with the sole exception of skew caused by impedance variation between the circuit board upon which the clock chip resides and other circuit boards of the system whose clock signals are supplied by the clock chip.

While this invention has been described in conjunction with the current embodiment illustrated in **Figures 1** through **3**, it is evident that numerous alternatives, modifications, variations and uses will be apparent to those skilled in the art in light of the foregoing description.

## Claims

1. A circuit fabricated on an integrated circuit chip for generating a plurality of synchronized output signals at one-half and one-fourth the frequency of an input signal, the circuit comprising:
receiving means for receiving said input signal;
first divider means electrically coupled to said input signal, said first divider means reducing the frequency of said input signal by one-half to provide a first signal;
a pair of first driving means each having an input and an output, the input of each of said first driving means electrically coupled to said first signal, the output of each of said first driving means electrically coupled to a first common point on the integrated circuit chip;
a plurality of second driving means each having an input and an output, the input of each of said second driving means electrically coupled to said first common point, such that the distance traveled by an electric current from said first common point to the input of each of said second driving means is substantially equal, the output of each of said second driving means providing a signal having the same form as said first signal;
second divider means electrically coupled to said first signal, said second divider means reducing the frequency of said first signal by one-half to provide a second signal;
a pair of third driving means each having an input and an output, the input of each of said third driving means electrically coupled to said second signal, the output of each of said third driving means electrically coupled to a second common point on the integrated circuit chip;
a plurality of fourth driving means each having an input and an output, the input of each of said fourth driving means electrically coupled to said second common point, such that the distance traveled by an electric current from said second common point to the input of each of said fourth driving means is substantially equal, the output of each of said fourth driving means providing a signal having the same form as said second signal.

2. A circuit fabricated on an integrated circuit chip for generating a plurality of synchronized output signals of the same form as an input signal, comprising:
receiving means for receiving said input signal;
a pair of first driving means each having an input and an output, the input of each of said first driving means electrically coupled to said input signal, the output of each of said first driving means electrically coupled to a common point on the integrated circuit die;
a plurality of second driving means each having an input and an output, the input of each of said second driving means electrically coupled to said common point, such that the distance traveled by an electric current from said common point to the input of each of said second driving means is substantially equal,
whereby the output of each of said second driving means provides a signal having the same form as said input signal.

3. The circuit defined by claim 1, wherein said first divider means comprises a first D-Q latch and said second divider means comprises a second D-Q latch.
